# EUROPEAN PATENT APPLICATION

(11) **EP 4 733 783 A1**
(43) Date of publication of application: **29.04.2026**
(21) Application number: 24208573.6
(22) Date of filing: 24.10.2024
(51) Int. Cl.: G01R 31/3842, H01M 10/48

(54) **BATTERY SENSING**

(71) Applicant: NXP USA, Inc., Austin, TX 78735 (US)
(72) Inventor: EL SHERIF, Alaa Eldin Y, 78735 Plano, TX (US); VOS, Eric Wayne, 95134 San Jose, CA (US); HARRELL, Steve Edward, 76210 Corinth, TX (US); KIM, Seongnam, 100-743 Seoul (KR); LEE, Jiyong, 100-743 Seoul (KR)
(74) Representative: Schmütz, Christian Klaus Johannes

(57) **Abstract**

The disclosure relates to methods and systems for gauging a state of charge of a battery (200) in a chargeable device. An example method of gauging a state of charge of a battery (200) in a chargeable device comprises: measuring a current (I_{DSG}, I_{CHG}, I_{SPM}) at a charge control transistor (102); measuring a voltage (V_{bat_sense}) of a battery (200); providing the measured current (I_{DSG}, I_{CHG}, I_{SPM}) at the charge control transistor (102) and the voltage (V_{bat_sense}) of the battery (200) to a processor (300); determining, using the processor (300), the state of charge of the battery (200).

## Description

### Field

The disclosure relates to methods and systems for gauging a state of charge of a battery in a chargeable device.

### Background

The ability to determine and monitor operating parameters of batteries in chargeable devices is a fundamental function that underpins many of the processes performed by modern electronics. Battery gauging (determining how much charge a battery has left) and battery charging (controlling the charging of the battery when coupled to an external power source) rely upon sensing the voltage, current and/or temperature of the battery.

Power management integrated circuits (PMICs) can be found in a wide range of chargeable devices. However, conventional PMICs and methods for performing battery sensing are typically optimised for portable electronic devices such as laptops and smartphones. Such devices usually have a large battery capacity, high power requirements and relatively short run times of usually less than 24 hours. In such devices, battery sensing is typically of low design importance. So long as users are provided with reasonably accurate battery gauging data and charging is performed safely, the power consumption and spatial requirements associated with PMICs are low priority considerations.

However, for devices that have small battery capacities, small physical dimensions, low operating powers, multi-day run times and/or low costs, even small improvements in battery sensing efficiency or hardware solutions can provide significant advantages.

### Summary

According to a first aspect there is provided a method of gauging a state of charge of a battery in a chargeable device, the chargeable device comprising a battery charging circuit comprising a charge control transistor, the charge control transistor being electrically coupled to the battery and to a load of the chargeable device and selectively operable such that the battery charging circuit can be selectively switched between a charging mode wherein an external power source is coupled to the battery charging circuit for charging the battery, and a discharge mode wherein the battery provides power to the load of the chargeable device, the method comprising: measuring a current at the charge control transistor; measuring a voltage of the battery; providing the measured current at the charge control transistor and the voltage of the battery to a processor; determining, using the processor, the state of charge of the battery.

Battery gauging and charging circuits are typically implemented as a standalone integrated circuit (IC) or as isolated circuits within a block-level integrated power management integrated circuit (PMIC). However, in either case, conventional battery fuel gauging apparatuses and methods rely upon a separate current sense resistor for measuring the current provided by the battery. By instead measuring the current at the charge control transistor, the external current sense resistor (and associated components, such as resistor-capacitor filters) can be eliminated. This means that the present battery fuel gauging disclosure can provided reduced circuit size, pin count and/or cost. The processor store software configured to determine the state of charge of the battery. Any suitable software may be used, but specific examples that may particularly advantageous when used with the methods/systems of the present disclosure are discussed below.

When the battery charging circuit is in the discharge mode, measuring the current at the charge control transistor may comprise: measuring a voltage drop across a drain connection and a source connection of the charge control transistor; and computing the current at the charge control transistor based on the measured voltage drop and an expected drain-source resistance of the charge control transistor.

Determining the current provided by the battery by measuring the voltage drop across the charge control transistor (e.g., across the drain-source on resistance (R_{DSon}) of the charge control transistor) may provide more accurate determination of current than other methods. This may be particularly important during the discharge mode, where accurate battery fuel gauging may be of greater importance compared to when the battery is being charged. However, this same current measuring method may also be used when the battery charging circuit is in the charging mode.

The method may further comprise: measuring a temperature of the charge control transistor using a temperature sensor located at or proximate to the charge control transistor; and determining the expected drain-source resistance based on the measured temperature of the charge control transistor.

When calculating the current via the voltage drop across the charge control transistor, current may be calculated as the voltage drop divided by resistance of the charge control transistor. However, the resistance of the charge control transistor may vary, due to environmental temperature changes and/or due to ohmic heating during operation of the chargeable device. The temperature sensor may be any suitable sensor (e.g., a negative temperature coefficient (NTC) thermistor or a resistance temperature detector (RTD)). The temperature sensor may be mounted on the IC board/die next to the charge control transistor. The measured temperature may be converted to a resistance value, using a look up table or a predetermined conversion factor, and this resistance value may be used alongside the measured voltage drop across the charge couple transistor to determine the current.

The battery charging circuit may further comprise a current mirror electrically coupled to the charge control transistor, the current mirror being configured to provide an output current based on the current at the charge control transistor. Measuring the current at the charge control transistor may comprise measuring the output current of the current mirror.

The current mirror may be any suitable current mirror device (e.g., a bipolar junction transistor (BJT) current mirror, a Wilson current mirror or a Widlar current mirror) and may copy the current through the charge control transistor and provide this as an output.

The current mirror may be used to measure the current at the charge control transistor when the battery charging circuit is in the charging mode. The battery charging circuit may be configured to automatically switch been measuring the current via voltage drop across the charge control circuit when in the discharge mode (discussed above) and via the current mirror when in the charging mode.

The charging mode of the battery charging circuit may be: a primary charging mode, wherein a voltage and/or current provided by the external power source exceeds a respective voltage requirement and/or current requirement of the load, and the external power source provides charge to the battery; or a supplement mode, wherein the voltage and/or current provided by the external power source is less than the respective voltage requirement an/or current requirement of the load, and battery provides power to the load.

The battery charging circuit may be configured to automatically switch between the primary charging mode and the supplement mode based upon measured voltages and/or currents of the external power source and the load.

The battery charging circuit may automatically switch between the primary charging mode and supplement mode based on determination that the voltage provided by the external charger is not sufficient to meet the demand of the load. In such a condition, charging of the battery may be deprioritised and instead the battery may discharge to supplement the external power source. This can prevent or reduce the likelihood of a drop-out of power to the chargeable device. Likewise, the battery charging circuit may automatically switch between the primary charging mode and supplement mode based on determination that the current provided by the external charger is not sufficient to meet the demand of the load. The present disclosure mainly refers to the provided/required voltages, but the skilled person will understand that the current may be used instead (e.g., by measuring current and providing this to the current measuring ADC). The battery charging circuit may automatically switch between the discharge mode and either of the charging modes based upon determination that an external power supply has been coupled to the battery charging circuit (e.g., that a voltage at an input port exceeds a threshold charging voltage).

The battery charging circuit may comprise a first analogue-to-digital converter (ADC) and a second ADC. Measuring the voltage of the battery may comprise receiving a raw battery voltage signal at the first ADC, the first ADC being configured to sample the raw battery voltage signal and output discrete battery voltage data samples. Measuring the current at the charge control transistor may comprise receiving a raw charge control transistor current signal at the second ADC, the second ADC being configured to sample the raw charge control transistor current signal and output discrete charge control transistor current data samples. The first and second ADCs may be configured to provide synchronised outputs such that each battery voltage data sample is associated with a charge control transistor current data sample.

The first ADC may be regarded as a voltage measuring ADC and may be configured to receive and sample the measured voltage of the battery (in addition to any other voltage measurements, such as a voltage from the temperature sensor discussed above). The second ADC may be regarded as a current measuring ADC and may be configured to receive and sample the measured current at the charge control (or a voltage used to determine said current, in both the charging and discharge modes).

The first and second ADCs may form part of an analogue front end (AFE). The analogue front end can provide consolidated voltage, current and temperature sensing circuitry compared to convention PMICs, thereby reducing the number of components required. Providing synchronised outputs from the two ADCs can enable the voltage to be sampled simultaneously with the current, which can enable a synchronous V and I data stream to be provided to the processor for determining the state of charge. Synchronous V/I sampling may support IR compensation (discussed further below), which can provide lower power consumptions than conventional coulomb counting-based methods of battery fuel gauging.

The battery charging circuit may further comprise a first multiplexer provided at an input of the first ADC and/or a second multiplexer provided at an input of the second ADC. The first multiplexer and/or the second multiplexer may further receive signal data from one or more monitoring components of the battery charging circuit.

Providing multiplexers for each of the first and second ADCs (as part of the analogue front end) can provide for many input signals to be received and sampled by the ADCs, in addition to the raw battery voltage signal and raw charge control transistor current signal discussed above. For example, the first ADC may also receive a voltage associated with the external power source such that the battery charging circuit can detect an over-voltage condition. The first ADC may receive a signal from one or more temperature sensors, which may be placed around the physical layout of the battery charging circuit and/or chargeable device, such that the battery charging circuit can detect an over-temperature condition.

Each charge control transistor current data sample may be appended with a mode identifier, the mode identifier indicating whether said charge control transistor current data sample was measured while the battering charging circuit was in the charging mode or the discharge mode.

For example, each charge control transistor current data sample may be a 14-bit data sample. Each data sample may be tagged with a 2-bit identifier to indicate whether said data sample was captured in the discharge mode, the primary charging mode or the supplement mode. The mode identifier may be provided to the processor along with the measured current and voltage data and may be used to adjust or refine the determination of the state of charge. For example, the current may be measured in the discharge mode using a voltage drop across the charge control transistor, while current may be measured in the charging mode using a current mirror. The charge control transistor and the current mirror may have different temperature dependencies, and thus the processor may be configured to compensate for current drift through the two different devices accordingly based upon the mode identifier.

The battery charging circuit may further comprise a buffer memory. Providing the measured current at the charge control transistor and the voltage of the battery to the processor may comprise: storing a plurality of charge control transistor current measurements and a plurality of battery voltage measurements in the buffer memory; and passing the plurality of charge control transistor current measurements and plurality of battery voltage measurements from the buffer memory to the processor.

By utilising a buffer memory to provide the charge control transistor current measurements and the plurality of battery voltage measurements, the power consumption associated with battery fuel gauging can be reduced. Compared to providing and analysing data continuously or on a sample-by-sample basis, collating a plurality of measurements in the buffer memory can allow the processor to remain in a low-power sleep mode for extended periods. The buffer memory may be a first in, first out (FIFO) or last in, first out (LIFO) data buffer implemented using any suitable storage hardware, for example.

A sample rate of the first ADC and a sample rate of the second ADC may be varied based on whether the battery charging circuit is in the charging mode or the discharge mode.

Varying the sample rate of the first ADC and second ADC can reduce the power consumption of the battery charging circuit. For example, a lower sampling rate may be utilised when the battery charging circuit is in the discharge mode since continuous or frequent monitoring may not be required. A frequency at which measurements are passed from the buffer memory to the processor may be variable based on whether the battery charging circuit is in the charging mode or the discharge mode.

As with the sample rate of the ADCs discussed above, varying the frequency that data is passed from the buffer memory to the processor can reduce the power consumption of the battery charging circuit; more infrequent use of the processor can allow the processor to remain in a sleep-mode for extended periods. The battery charging circuit may be configured to only pass data when the buffer memory is filled to a certain threshold and/or at variable time intervals, for example.

The frequency of ADC sampling and/or buffer memory usage may be varied based on other factors other than the charging mode. For example, the frequency may be reduced when the determined state of charge falls below a predetermined threshold, so as to conserve battery when charge is low.

Determining the state of charge of the battery may comprise using an IR corrected voltage correlation model.

The IR corrected voltage correlation model may be used alongside a model of the battery's impedance in order to determine the state of charge. Simultaneous measurement of the voltage and current, as described may allow for sufficiently accurate estimation of battery charge (compared to conventional coulomb counting methods) but with reduced power consumption.

Measuring the voltage of the battery may comprise taking a differential measurement of the voltage of the battery, the differential measure comprising applying a reference offset voltage to the measured voltage.

By taking a differential measurement of the battery, a higher gain may be provided at the input of the measured battery voltage. Combined with the reference offset voltage, the voltage may be 'zoomed in' to focus on a particular voltage range of interest (e.g., 4.5 V to 2.0 V for typical lithium-ion batteries). This can increase the accuracy and/or precision of the measurement of the battery voltage.

According to a second aspect there is provided a system for gauging a state of charge of a battery in a chargeable device, the system comprising: a battery charging circuit comprising: a charge control transistor, the charge control transistor being electrically coupled to the battery and to a load of the chargeable device and selectively operable such that the battery charging circuit can be selectively switched between a charging mode wherein an external power source is coupled to the battery charging circuit for charging the battery, and a discharge mode wherein the battery provides power to the load of the chargeable device; a current measuring pathway configured to measure a current at the charge control transistor; a voltage measuring pathway configured to measure a voltage of the battery; a first analogue-to-digital converter, ADC, coupled to the voltage measuring pathway, the first ADC being configured to receive a raw battery voltage signal and output discrete battery voltage data samples; and a second ADC coupled to the current measuring pathway, the second ADC being configured to receive a raw charge control transistor current signal and output discrete charge control transistor current data samples, wherein the first ADC and the second ADC are configured to provide synchronised outputs; and a processor, the processor being coupled to the first and second ADCs and being configured to determine a state of charge of the battery based upon the measured current at the charge control transistor and the measured voltage of the battery.

The battery charging circuit may further comprise a buffer memory configured to: receive the outputs of the first ADC and the second ADC; store a plurality of storing a plurality of charge control transistor current measurements and a plurality of battery voltage measurements; and pass the plurality of charge control transistor current measurements and plurality of battery voltage measurements from the buffer memory to the processor.

The system of the second aspect may be used to implement the method of the first aspect.

The skilled person will understand that the system may comprise any suitable components that can be used to provide a battery charging circuit, in addition to those discussed above. For example, additional resistors, capacitors, filters, etc. may be provided in order to enable safe charging of the battery and battery fuel gauging. One or more components may be provided as discrete devices. For example, the battery charging circuit and the buffer memory may be provided on a single IC device so as to act as a PMIC. The processor may be an external microcontroller unit (MCU) which receives one or more output signals from the PMIC. The battery charging circuit may be coupled to any suitable battery/chargeable device, so that the advantages discussed herein may be applied to said chargeable device.

The chargeable device may be a wearable device. The battery may have a maximum storage capacity of less than 500 mAh.

The methods and systems of the present disclosure may be particularly advantageous when used in devices with small battery capacities (e.g., less than 1 Ah, less than 500 mAh, or less than 250 mAh). The battery in question may be a lithium-ion battery, but the present disclosure is applicable to any suitable battery technology. Such devices typically have small system sizes and low power requirements - such as wearable devices (e.g., watches, health trackers, etc.) or internet of things (IoT) devices - and may have multi-day run times. The power consumption reductions discussed above may be particularly advantageous when used with devices having small battery sizes, as small reductions in battery fuel gauging processes can significantly improve battery life. Likewise, the reduction in the number of components (e.g., the removal of an external current sense resistor) may be particularly advantageous in small and/or low-cost devices.

The use of an IR corrected voltage correlation model as described above, rather than conventional coulomb counting-based approaches, may also be particularly advantageous when used in wearables and other devices with small batteries/power output. Coulomb counting techniques are usually optimised for devices with larger batteries (e.g., laptop computers or smartphones). These devices usually have a fairly continuous and consistent battery discharge profile, with run times of approximately 24 hours or less. By contrast, small, low-power systems typically have a small-sized Li-Ion battery with relatively high internal cell impedance and intermittent discharge profiles followed by long periods of inactivity, and run times that may last multiple days. Compared to coulomb counting, the IR corrected voltage correlation model - which may be enabled by the simultaneous voltage/current measurement of the present disclosure - may reduce the power consumption of battery fuel gauging in such devices with small batteries and 'bursty' discharge profiles. According to a third aspect there is provided a chargeable device, the chargeable device comprising: a chargeable battery; and system for gauging a state of charge of the chargeable battery, the system comprising a battery charging circuit and a processor.

The system for gauging a state of charge may be according to the second aspect. The system may be operated so as to implement the method of the first aspect. The chargeable device may be a wearable device (e.g., a smartwatch) or an IoT device. The chargeable battery may have a maximum storage capacity of 500 mAh.

According to a fourth aspect there is provided a method of gauging a state of charge of a battery in a chargeable device, the chargeable device comprising a battery charging circuit comprising a buffer memory, the method comprising: measuring, via the battery charging circuit, a voltage and a current of the battery; repeating the measurement of the voltage and current of the battery so as to produce a plurality of voltage data samples and a plurality of current data samples, and storing the plurality of voltage data samples and the plurality of current data samples in the buffer memory; providing the plurality of voltage data samples and the plurality of current data samples stored in the buffer memory to a processor; and determining, using the processor (300), the state of charge of the battery.

As discussed above, the use of buffer memory as in the fourth aspect may be used alongside the first, second and third aspect; the present disclosure provides examples of these features being used in combination. However, the use of a buffer memory for storing voltage and current data samples may be independent of other aspects of the present disclosure. A buffer memory may be utilised in a battery charging circuit that does not measure current at a charge control transistor, that does not have a dual-ADC analogue front end and/or does not utilise an IR corrected voltage correlation model for estimating the state of charge, for example. Buffer memory may be incorporated in any suitable battery gauging system. Storing a plurality of data samples in other battery gauging systems may still provide the benefits discussed above - data may be provided to the processor less frequently, which may reduce power consumption associated with battery gauging.

These and other aspects of the invention will be apparent from, and elucidated with reference to, the embodiments described hereinafter.

### Brief description of Drawings

Embodiments will be described, by way of example only, with reference to the drawings, in which:
Figure 1 is a schematic diagram of an example system for gauging a state of charge of a battery in a chargeable device according to the present disclosure;
Figure 2 is a schematic diagram of an example system for gauging a state of charge of a battery in a chargeable device according to the present disclosure;
Figure 3 is a flow diagram illustrating how battery gauging system can be switched between different charge/discharge modes;
Figure 4 is a schematic diagram of an example current sensing circuit that may be used in battery gauging systems/methods of the present disclosure; and
Figure 5 is a schematic diagram of an example voltage sensing circuit that may be used in battery gauging systems/methods of the present disclosure.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

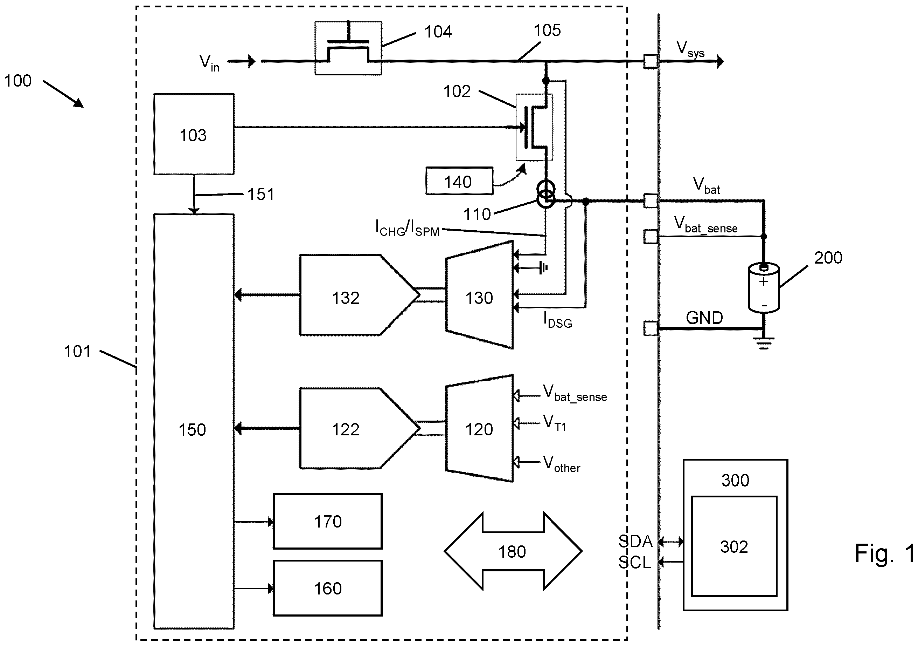

Figure 1 shows a schematic diagram of a system 100 for gauging a state of charge of a battery 200. The system 100 and battery 200 may be incorporated into a chargeable device (not shown), such as a wearable device of Internet of Things (IoT) device. The battery may be a small (e.g., less than 500 mAh capacity) lithium-ion battery, like those found in portable devices such as smartwatches.

Some or the majority of the components of the system 100 may be provided as a single device, such as on a single integrated circuit (IC) board. Thus, these 'packaged' components may collectively be regarded as a power management integrated circuit (PMIC) or a battery charging circuit 101. The PMIC 101 has connection ports or pins such that the components therein can be electrically coupled to other devices, such as the battery 200 itself and a micro controller unit (MCU) / processor 300.

The system 100 comprises a charge control transistor 102. One of a source or drain connection of the charge control transistor is coupled to a terminal of the battery 200. The other of the source or drain connection of the charge control transistor is coupled to a supply line 105. The supply line 105 is coupled to a supply input (e.g., a charging port) which is configured to a receive an input voltage Vᵢₙ from an external power source (not shown). The supply line 105 is also coupled to a supply output which is configured to provide a system voltage V_{sys} to other components of the wider chargeable device. A gate connection of the charge control transistor 102 is coupled to a charge controller 103. The charge controller 103 is configured to provide a control signal to the gate of the charge control transistor 102 so as to control the direction and flow of current through source-drain path of the charge control transistor 102. The charge control transistor 102 may be referred to as a battery field effect transistor (BATFET).

By varying the control signal provided to the gate of the charge control transistor 102, the charge controller 103 can switch the battery charging circuit 101 between various modes. When the external power source is not coupled to the supply input (i.e., no input voltage Vᵢₙ is provided), the charge control transistor 102 may be switched to a discharge mode whereby the battery 200 discharges such that the battery powers the chargeable device, with current flowing between the battery 200 and the supply output via the charge control transistor 102 and the supply line 105. When the external power source is coupled to the supply input, the charge control transistor 102 may be switched to a charging mode. For sufficient input voltages Vᵢₙ, the battery charging circuit 101 may be in a primary charging mode whereby the external power source charges the battery 200. The external power source may also be used to simultaneously provide system voltage V_{sys} to the chargeable device via supply line 105. Where the input voltage Vᵢₙ provided is not sufficient to power the chargeable device while charging the battery 200, the battery charging circuit 101 may be switched to a supplement mode whereby the charging is deprioritised and the battery 200 temporarily discharges (or at least does not draw charging power) to supplement the external power supply and ensure that the system voltage V_{sys} provided to the chargeable device is sufficient.

A charge limiting transistor 104 may be provided on the supply line 105 upstream of the charge control transistor 102 and the supply output. The charge limiting transistor may be referred to as a limiting field effect transistor (LIMFET). Source and drain connections of the charge limiting transistor are connected in series with the supply line 105 and external power source. A gate connection of the charge limiting transistor 104 is coupled to a limit controller (not shown). By varying the voltage provided to the gate of the charge limiting transistor 104, the current provided by the external power supply to the battery 200/chargeable device may be limited or controlled. The charge limiting transistor 104 may therefore be used to control the rate of charge of the battery 200 so as to prevent damage, or to reduce likelihood of a current surge in the external power supply damaging the battery 200 or wider chargeable device.

The system 100 further comprises a first multiplexer 120 coupled to an input of a first analogue to digital converter (ADC) 122, and a second multiplexer 130 coupled to an input of a second ADC 132. The multiplexers 120, 130 may be differential multiplexers, for example. Inputs of the multiplexers may be passed through additional signal processing components such as filters or amplifiers. The ADCs may be successive approximation (SAR) ADCs, for example.

The first multiplexer 120 and first ADC 122 may form a voltage measuring pathway. A first input of the first multiplexer 120 is coupled to the same terminal of the battery 200 as the charge control transistor 102 and measures an output voltage V_{bat_sense} of the battery 200 (e.g., the voltage across the battery 200 relative to a common ground rail GND). In the example circuit of Figure 1, the measured battery output voltage V_{bat_sense} is provided as a separate pin/connection on the battery charging circuit 101 to the actual battery output voltage V_{bat} that is coupled to the charge control transistor 102. However, a single pin/connection may be provided, with the measured battery voltage V_{bat_sense} being taken from a junction of the V_{bat} supply to the charge control transistor 102.

The second multiplexer 130 and second ADC 132 may form a current measuring pathway. A first input of the second multiplexer 130 is coupled to a current mirror 110. The current mirror 110 is coupled to the same terminal of the battery 200 as the charge control transistor 102, and therefore mirrors a current flowing across the charge control transistor 102 (and thus the current provided to/from the battery 200). The current mirror 110 may be configured to measure a current I_{CHG}/I_{SPM} at the charge control transistor 102 when the battery charging circuit 101 is in the primary charging or supplement mode. A second input of the second multiplexer 130 is coupled across the drain and source connections of the charge control transistor 102 and is configured to measure a voltage drop across the charge control transistor 102 when the battery charging system is in the discharge mode. The measured voltage drop can be used to infer a current I_{DSG} at the charge control transistor 102 based on an expected drain-source resistance Roson of the charge control transistor 102.

The system 100 further comprises a temperature sensor 140. The temperature sensor 140 is located at or proximate to the charge control transistor 102, so as to measure a temperature of the charge control transistor 102. For example, the temperature sensor 140 may be mounted on the IC board/die next the charge control transistor 102 so that the two are thermally coupled. As the temperature of the charge control transistor 102 increases, the resistance Roson across the transistor may increase - i.e., the relationship of Roson v temperature may have a positive slope. The temperature of the charge control transistor 102, as measured by the temperature sensor 140, may be used to compensate for the change in resistance of the charge control transistor 102. Thus, the measurement of current at the charge control transistor 102 - based on the drain-source voltage drop and the resistance Roson - may be more accurate. A second input of the first multiplexer 120 may receive a temperature measurement signal V_{T1} from the temperature sensor 140.

The current mirror 110 may also exhibit a temperature variation, meaning that the output of the current device that is provided to the second multiplexer 130 when operating in the primary charging or supplement mode may have a similar error. Similar to the compensation of the charge control transistor resistance R_{DSon} discussed above, temperature may be measured at or proximate to the current mirror 110, with the measured temperature being provided to the first multiplexer and used to more accurately determine the current at the charge control transistor 102. The same temperature sensor 140/temperature measurement signal V_{T1} may be used for both the charge control transistor 102 and the current mirror 110. Alternatively, a second temperature sensor may be provided for the current mirror 110, with a second temperature measurement signal being provided to and sampled by the first multiplexer 120 and first ADC 122.

Together, the first and second multiplexers 120, 130 and the first and second ADCs 122, 132 may be regarded as an analogue front end (AFE) for receiving voltage, current and temperature measurements relating to the battery 200 and its charging/discharging status. By providing separate voltage and current measurement pathways via the two ADCs 122, 132, the voltage and current of the battery 200 (as measured at the charge control transistor 102) can be measured simultaneously. In addition to the current measurements I_{DSG}/I_{CHG}/I_{SPM}, the voltage measurement V_{bat_sense} and charge control transistor temperature measurement V_{T1}, the multiplexers may be provided with further input signals related to other operating parameters (collectively shown as Vₒₜₕₑᵣ and discussed further below).

The first ADC 122 receives the raw battery voltage signal (i.e., the battery voltage V_{bat_sense} as received at the first multiplexer 120), samples the signal, and outputs discrete battery voltage data samples. Likewise, the second ADC 132 receives the raw charge control transistor current signal (i.e., the signal I_{CHG}/I_{SPM} as measured by the current mirror 110 or the signal I_{DSG} as measured by the voltage drop across the charge control transistor 102), samples the signal, and outputs discrete charge control transistor current data samples. The ADCs may be synchronised (e.g., they may have a common frequency input) such that the voltage and current data samples are synchronised. Thus, a concurrent stream of paired voltage and current measurements may be output by the dual-ADC AFE.

The first ADC 122 also samples the raw temperature measurement signal V_{T1} as received by the first multiplexer 120 from the temperature sensor 140. The raw signal is sampled and the first ADC 122 outputs discrete charge control transistor temperature data samples. The temperature of the charge control transistor 102 may be sampled infrequently (e.g., less that the current and voltage), which may reduce the power consumption associated with temperature measurements. Temperature may not be expected to fluctuate rapidly in real world applications, and so lower sampling rates compared to voltage/current may be sufficient.

The digital data outputs of the first and second ADCs (the voltage, current and temperature measurements) are provided to an AFE controller 150. The AFE controller 150 is configured to control to the sampling performed by the ADCs 122, 132 and to collate the parameter measurements of the battery charging circuit 101 discussed above. The AFE controller 150 may be an MCU or other processor.

The AFE controller 150 tags each of the charge control transistor current data samples with a mode identifier, the mode identifier identifying which mode the battery charging circuit 101 was in at the time that the charge control transistor data sample was acquired. The mode identifier may be determined based on a mode selection signal 151 provided by the charge controller 103 to the AFE controller 150, the mode selection signal 151 indicating the selected mode of the battery charging circuit 101. Each charge control transistor current data sample may be a 14-bit data sample, and the mode identifier may be 2 bits (sufficient to indicate the discharge mode, primary charging mode and supplement mode), for a total of 16 bits. Alternatively, the corresponding battery voltage data samples may be tagged with the mode identifiers.

The battery charging circuit 101 further comprises a buffer memory 160. The buffer memory 160 may be a first in, first out (FIFO) or last in, first out (LIFO) data buffer implemented using any suitable storage hardware, for example. The AFE controller 150 outputs paired voltage and current data samples, each pair having a mode identifier as discussed above. The buffer memory 160 is configured to store a plurality of voltage and current data samples, before these are output to the processor 300. The buffer memory 160 may be configured to output the plurality of data samples at a given frequency (which may be controlled by an output signal provided by the AFE controller 150) or when the buffer memory 160 reaches a given full threshold. Charge control transistor temperature data samples may also be stored in buffer memory 160 and output to the processor alongside the voltage and current data. By holding the voltage, current and temperature data in the buffer memory 160 and only outputting this to the processor 300 periodically, the processor 300 may be retained in a low-power or a sleep mode until required.

The system 100 may further comprise additional data storage such as a one-time programmable (OTP) memory 170. The OTP memory 170 may be used to store compensation or trim values for components of the battery charging circuit, which may also be output to the processor 300. For example, the OTP memory 170 may store trim data for temperature drift compensation of the charge control transistor 102 drain-source resistance R_{DSon}. The trim data may provide a slight adjustment to the determined drain-source resistance that may arise due to variability in the manufacturing of the charge control transistor 102. The trim data may be a single compensation value; this may be sufficiently accurate based on corners-lot characterisation of the transistor semiconductor material. Alternatively, the trim data may comprise multiple compensation values for different temperatures, e.g., a hot and an ambient compensation value. The use of multiple compensation values may improve the accuracy of the subsequent fuel gauging determination across the system 100's normal operating temperature range. The trim values may be stored on the OTP memory 170 during manufacturing. The trim values may then be output to the processor 300 during an initialisation process of the system 100 and subsequently used as required in determining the state of charge of the battery 200.

The OTP memory 170 may be used to store trim values for other components in addition to or instead of the charge control transistor 102. The OTP memory may also store trim values for the current mirror 110, for example, which may compensate for variance between different current mirrors caused by manufacturing variability. Said current mirror device trim value(s) may be output to the processor 300 similarly to as discussed above, so as to enable more accurate fuel gauging when the system 100 is instead operating in the primary charging or supplement modes.

The buffer memory 160 and OTP memory 170 are coupled to the processor 300 via a data connection line or a communications serial bus 180, thereby allowing data to be read from the battery charging circuit 101. The communications serial bus 180 may be an I²C or an I3C communications bus, for example, and have a serial data line (SDA) and serial clock line (SCL) for transferring data accordingly.

The processor 300 may be any suitable computing processor, such as a microprocessor unit (MCU). The processor 300 may be external to the battery charging circuit 101. For example, the battery charging circuit 101 may be provided on one IC board, while the processor 300 may be a separate unit.

The processor 300 receives the buffered data from the battery charging circuit 101. A control signal/data ready signal may be provided to the processor 300 prior to transmitting the buffered data so as to wake the processor 300 from a sleep mode. The processor 300 may store software 302 for determining the state of charge of the battery 200 based on the data provided by the battery charging circuit 101.

The processor 300 converts the current data sample to a current by dividing the measured voltage by the expected resistance. For example, when in the discharge mode, the current I_{DSG} is measured via the voltage drop (V_{bat} - V_{sys}) across the drain-source on resistance R_{DSon} of the charge control transistor 102. In order to account for temperature-induced variation of R_{DSon}, the processor may determine the expected resistance based on the temperature data provided by the temperature sensor 140. The resistance may be determined from a lookup table of temperature-resistance pairs or may be calculated using a known resistance vs temperature relationship of the charge control transistor, for example. Where the temperature of the current mirror 110 is also measured, temperature compensation may be performed similarly when the battery charging circuit 101 is in the primary charging or supplement mode.

In addition to adjusting the current measurements based on temperature data provided by a temperature sensor, the processor 300 may utilise trim values provided by the OTP memory 170 as discussed above to provide further compensation (e.g., to counteract manufacturing variability), as discussed above. Trim values may be provided to compensate resistance variance for both the charge control transistor 102 and the current mirror 110.

The processor 300 may read the tagged mode identifier for each pair of voltage and current data samples, so as to determine under which the battery charging circuit 101 was operating at the time of obtaining said samples. Based upon the determined mode, the apparatus may provide the temperature-based and trim value-based compensation discussed above accordingly. For example, when the mode identifier indicates that the battery charging circuit 101 was in the discharge mode, the current is determined based upon the temperature-resistance dependence of the charge control transistor 102. However, when the mode identifier indicates that the battery charging circuit 101 was in the primary charging or supplement mode, the current is determined based upon the temperature dependence of the current mirror 110.

Regardless of any compensation as discussed above, the processor 300 receives synchronous voltage and current data from the battery charging circuit 101. The software 302 for determining the state of charge comprises an algorithm that utilises the synchronous voltage and current data in an open circuit voltage (OCV) model. The OCV model may comprise comparing the measured voltage of the battery to a lookup table to determine an estimated state of charge (SOC). Where the current is non-zero (as determined by the current measurements at the charge control transistor 102), IR correction may be applied to the OCV model in order to account for the voltage drop that is expected when the battery is placed under load. The software 302 may also comprise an impedance model of the battery 200. The impedance model may also be used to adjust the IR-corrected OCV model estimation; battery impedance may impact the voltage drop of the battery, thus altering the estimated SOC. The algorithm discussed above is just one example of how SOC of the battery can be estimated in the system 100. The software 302 may comprise any suitable algorithm that can estimate SOC based on the current, voltage and/or temperature measurements provided by the battery charging circuit 101.

Providing synchronous voltage and current measurements via the AFE of the battery charging circuit 101 may allow for more accurate SOC estimation, as the voltage and current that are used in the IR-corrected OCV model are measured simultaneously. Additionally, this data may be buffered in buffer memory 160 as discussed above, with the processor 300 only being used intermittently to determine the SOC. Thus, this method of determining the SOC may result in lower processor power consumption compared to methods that act continuously, such as coulomb-counting based approaches.

The processor 300 may be external to the battery charging circuit 101 of the present disclosure, as shown in Figure 1. The processor may be existing MCU of the chargeable device that is already configured to provide charging capabilities (e.g., controlling charging/discharging of the battery 200). The software 302 may comprise pre-existing components, such as drivers for controlling hardware of the chargeable device. The pre-existing components may then be supplemented with the battery gauging algorithm discussed above along with any other software required for integration of the present disclosure into the existing MCU (e.g., a hardware abstraction layer, that enables the specifics of each system 100 to be used by the algorithm; configuration data which may be specific to each system 100, such as specific communication protocols; and the battery gauging model itself, which may be specific to the battery 200 in question and comprise system-specific parameters such as a battery impedance model). The existing MCU of the chargeable device may provide sufficient computational and memory resources to host the battery charging algorithm of the present disclosure, meaning that existing chargeable device hardware can be efficiently re-used for this purpose. This can reduce the overall size, cost and power consumption of the system 100. Using the existing MCU can also allow for rapid debugging of the software 302, easily deployable system updates, and/or system-specific customisation of the software 302. These advantages may be particularly apparent for Internet of Things (IoT) or 'smart' wearable devices, for example, which already have relatively powerful built in processors and existing wireless communication capability. Alternatively, the processor 300 may be a discrete, system-specific processor that is part of the battery charging circuit 101, such that the system 100 is standalone (except for, optionally, the battery 200) and can be applied to any chargeable device.

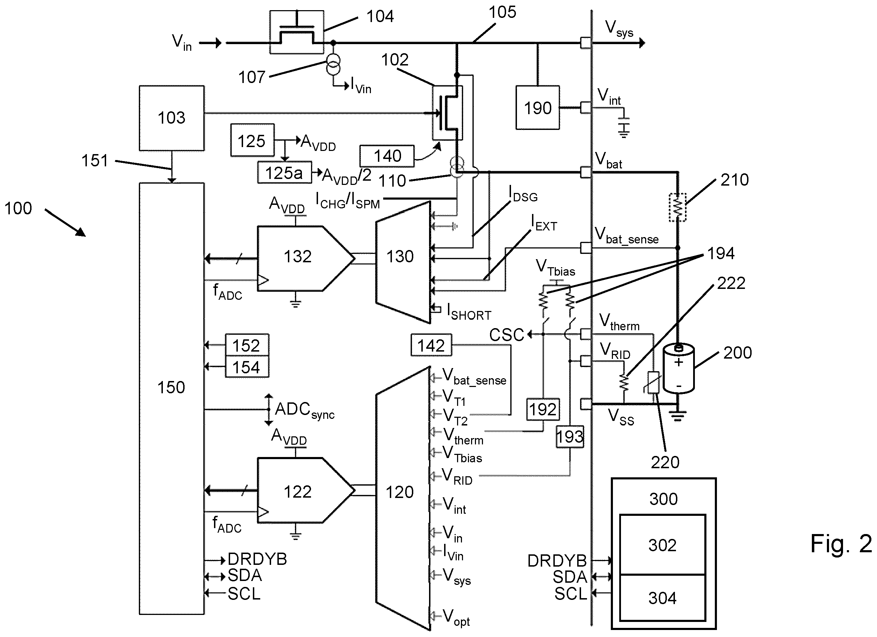

Figure 2 shows a schematic diagram of a system 100 for gauging a state of charge of a battery 200. The system 100 of Figure 2 is similar to that of Figure 1; corresponding features shown in Figure 2 may be configured and operate as described as above for Figure 1. The system 100 shown in Figure 2 comprises some optional modifications and additions that may be made relative to the system 100 shown in Figure 100. The battery charging circuit 101 is not labelled in Figure 2 for clarity, but, nonetheless, components other than the battery 200 and processor 300 may be regarded as the battery charging circuit 101.

The system 100 further comprises a second current mirror device 107. The second current mirror device 107 is coupled to an output of the charge limiting transistor 104. The second current mirror device 107 outputs an input current signal I_{Vin} that mirrors the current provided by the external power source (not shown) through the charge limiting transistor 104 to the battery 200 and/or chargeable device. The input current signal Ivin may be received by the AFE (e.g., at the first multiplexer 120) so that it can be processed and analysed. The input current signal I_{Vin} may be used to sense an overcurrent condition, for example as a result of a faulty external power supply. The system 100 may then respond accordingly to prevent damage; the voltage provided to a gate connection of the charge limiting transistor 104 may be varied to reduce the current passing therethrough, for example.

The system 100 further comprises an power supply 125, configured to output a power supply voltage A_{VDD}. The power supply voltage A_{VDD} may be provided to any of the components of the AFE or the wider system 100 so as to power said components. The power supply voltage A_{VDD} may be provided to the first ADC 122 and the second ADC 132, as shown in Figure 2, for example. The power supply voltage A_{VDD} may be 1.536 V. The system 100 may also comprise one or more power supply converters 125a. These may be configured to take the power supply voltage A_{VDD} and output a converted voltage which may be used to power other components that require lower voltage inputs. In the example of Figure 2, the power supply converter is configured to output a converted voltage of A_{VDD}/2.

The system 100 may further comprise one or more additional temperature sensors 142, in addition to the temperature sensor 140 located at or proximate to the charge control transistor 102. The additional temperature sensor 142 outputs a second temperature measurement signal V_{T2} to the first multiplexer 120. An additional temperature sensor 142 may be located at or proximate to the current mirror 110, in order to provide temperature compensation for current measurements in the primary charging or supplement mode (as discussed above). Additionally or alternatively, an additional temperature sensor 142 may be located near AFE components in order to provide overheating protection for the battery charging circuit 101.

The system 100 further comprises one or more oscillators. In the example of Figure 2, the system comprises a first oscillator 152 and a second oscillator 154). The oscillators 152, 154 are configured to output two different frequency signals. The first oscillator 152 may output a frequency signal at 32 kHz and the second oscillator 154 may output a frequency signal at 2 or 4 MHz, for example. The frequency signals produced by the oscillators 152, 154 are provided to the AFE controller 150. The frequency signals may be used by the AFE controller 150 to control other components of the system 100. The AFE controller 150 may output an ADC frequency control signal f_{ADC} that determines the sampling frequency of the first ADC 122 and the second ADC 132. By varying the frequency of the ADC frequency control signal f_{ADC}, the ADCs 122, 132 may be put into a low power, low sampling frequency mode or a higher power, higher frequency sampling mode as necessary. The AFE controller 150 may also output an additional synchronisation signal ADC_{sync}, which may be received by the multiplexers 120, 130 and/or the ADCs 122, 132 to ensure that voltage and current measurements are taken simultaneously. The AFE controller 150 may provide frequency control signals to other components of the system based on the frequency signals provided by the oscillators 152, 154. The AFE controller 150 may control the rate at which data is transferred from the buffer memory 160 (shown in Figure 1) to the processor 300.

The system 100 may further comprise components that can provide for additional monitoring and battery gauging capabilities to those discussed above. The system 100 may comprise a low-dropout (LDO) regulator 190. The LDO regulator 190 may receive an internal reference voltage Vᵢₙₜ and be coupled to the supply line 105, so as to regulate the system voltage V_{sys}. The LDO regulator 190 may therefore allow for a smoother system voltage V_{sys} to be provided to the chargeable device. The supply line 105 may be provided with any suitable regulator device.

The system 100 may also comprise an external current sense resistor 210. Although the charge control transistor 102 methods of measuring current discussed above can provide for battery gauging with reduced power consumption, the system 100 may utilise an external current sense resistor 210 in certain conditions, e.g., where the system 100 is in primary charge mode or where the battery fuel level is above a certain threshold. The use of the external current sense resistor 210 may enable more accurate determination of the state of charge of the battery 200. The current is determined by measuring the voltage drop across the current sense resistor 210 (V_{bat_sense} - V_{bat}) at the second multiplexer 130 / second ADC 132 (indicated by external current measurement I_{EXT} in Figure 2). Despite the external current sense resistor 210, current can still be measured via the voltage drop across the charge control transistor (I_{DSG} when in the discharge mode) and/or via the current mirror 110 (I_{CHG} when in the primary charging mode or I_{SPM} when in the supplement mode).

The system 100 may further comprise a thermistor or other temperature sensitive device located proximate to the battery 200. The device may be a negative temperature coefficient (NTC) thermistor 220, for example. The NTC thermistor 220 outputs a battery temperature signal Vₜₕₑᵣₘ based upon the temperature of the battery 200. The battery temperature signal Vₜₕₑᵣₘ may be provided to the first multiplexer 120 and/or to a separate charger safety comparator CSC. Charging and/or discharge of the battery 200 may be controlled based upon the battery temperature signal Vₜₕₑᵣₘ. For example, if the battery temperature measured by the NTC thermistor 220 during charging is too high, charging may be paused.

The system 100 may further comprise a resistor 222 coupled in parallel with the battery 200. An output of the resistor 222 may be provided to the first multiplexer 120 as a battery resistor identification signal V_{RID}. Based upon the signal, the system 100 may be able to determine the internal resistance and/or battery type of the battery 200. This information may be provided to the processor 300 and may be taken into account when determining the state of charge of the battery 200.

The NTC thermistor 220 and the resistor 222 are coupled to the negative terminal of the battery 200. The negative voltage Vss may be supplied to the system 100 and function as a ground. The battery temperature signal Vₜₕₑᵣₘ and the battery resistor identification signal V_{RID} may each be coupled to the first multiplexer by a general-purpose input/output (GPIO) connection 192, 193. The GPIO connections 192, 193 may be pins on the IC board that the battery charging circuit 101 is located on, allowing connection to external components such as the NTC thermistor 220 and the resistor 222. The battery temperature signal Vₜₕₑᵣₘ and the battery resistor identification signal V_{RID} may be coupled to a switchable pair of resistors 194 that receive a thermal bias voltage V_{Tbias}. Depending upon the switching state of the resistors 194, the battery temperature signal Vₜₕₑᵣₘ and/or the battery resistor identification signal V_{RID} may be adjusted by the thermal bias voltage V_{Tbias}.

Compared to the simplified version of the system 100 shown in Figure 1, the first multiplexer 120 and second multiplexer 130 each comprise many more channels for receiving additional signals. These additional channels can be used to provide additional battery and system sensing capabilities, as discussed above. The first multiplexer 120 may optionally be provided with additional inputs Vₒₚₜ to provide additional functionality. For example, the first multiplexer 120/first ADC 122 may be provided with output signals from the LDO regulator 190 and/or the switchable resistors 194, so as monitor the state of these and adjust other components or instruct the processor 300 to take the operating states of these into account accordingly. The second multiplexer 130 may comprise a short signal Iₛₕₒᵣₜ that may be used as a reference.

Compared to the system 100 of Figure 1, the system 100 of Figure 2 does not have a buffer memory 160, OTP memory 170 or serial bus 180. These features may be excluded, with the voltage/current/temperature measurement data samples instead being provided as a data stream to the processor 300 directly. In the example of Figure 2, a serial data line (SDA), data acquisition ready line (DRDYB) and a serial clock line (SCL) connect the AFE controller 150 to the processor 300. The data acquisition ready line DRDYB may be used to wake up the processor when measurement data samples are ready to be processed. In addition to comprising software 302 for battery gauging, the processor 300 may comprise additional software or drivers 304 for interfacing with the battery charging circuit 101.

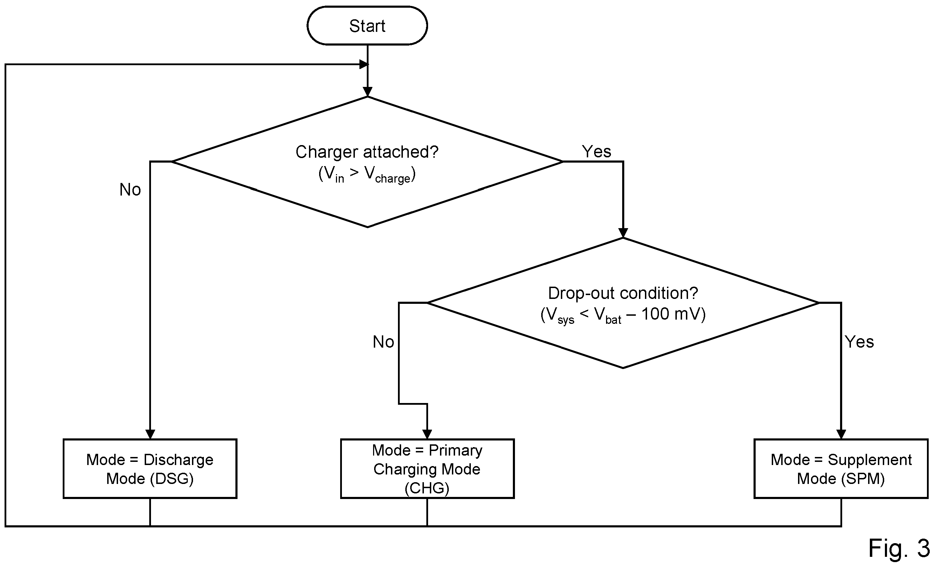

Figure 3 shows a flow diagram for an example process for switching the mode of the battery charging circuit 101. At a first step, it is determined whether an external power supply is coupled to the supply input of the system 100. This may be determined by comparing the received input voltage Vᵢₙ to a threshold charging voltage V_{charge}. If Vᵢₙ is not greater than V_{charge} (e.g., no external power supply is connected or the external power supply is not sufficient to charge the battery 200), the battery charging circuit is switched to the discharge mode DSG. If Vᵢₙ is greater than V_{charge}, then at a second step it is determined whether a drop-out condition of the chargeable device may occur. This may be determined by comparing the system voltage V_{sys} provided to the chargeable device against the output voltage V_{bat} of the battery 200. If V_{sys} is less than V_{bat} minus a safety margin (e.g., 100 mV), the chargeable device may be at risk of a drop-out condition. Therefore, the battery charging circuit 101 is switched to the supplement mode SPM so that the battery 200 can temporarily supplement the external power supply in powering the chargeable device. However, if V_{sys} is not less than V_{bat} minus the safety margin, the battery charging circuit 101 is switched to the primary charging mode whereby battery 200 is charged by the external power supply. Alternatively, the drop-out condition may be assessed by comparing a current provided to the rest of the chargeable device (i.e., system current) to an output current of the battery 200. The output current of the battery may be measured using the aforementioned current measuring means, e.g., the current at the charge control transistor 102, the current mirror 110 or the external current sense resistor 210.

Vᵢₙ, V_{charge}, V_{sys} and V_{bat} may also be provided to a processor configured to perform the comparison discussed above. The processor may be part of the charge controller 103, the AFE controller 150, or an additional separate processor. Once it is determined which mode the battery charging circuit 101 is to be switched to, this information may be passed to the charge controller 103 to operate the charge control transistor 102 and any other necessary components accordingly.

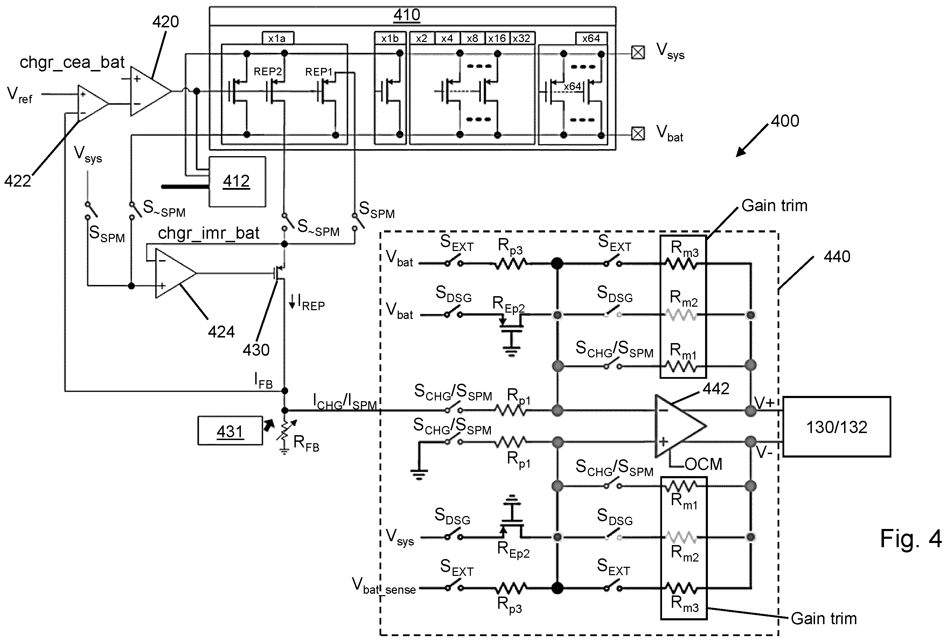

Figure 4 shows a schematic diagram of a current sensing circuit 400. The current sensing circuit 400 may be provided as part of the system 100 shown in Figures 1 and 2 for allowing current to be sensed while the system 100 is operated in the various charging modes discussed above, with the current signals being provided to the second multiplexer 130 / second ADC 132 accordingly.

The current sensing circuit 400 comprises a stack 410 of transistors arranged in parallel to one another, with the gates of each transistor being linked. A source connection of each transistor in the stack 410 is coupled to the system voltage V_{sys} while a drain connection of each transistor in the stack 410 is coupled to the battery output voltage V_{bat}. Each of the transistors in the stack 410 functions as a bit, with the source and gate connection of each transistor being coupled to a decoder 412, the decoder 412 being configured to digitally control each transistor bit. The stack 410 shown in Figure 4 is a 64-bit stack, for example.

Each gate connection of the transistors is coupled to the output of a charge error amplifier 420. The charge error amplifier 420 receives as a positive input a chgr_cea_bat signal (a control signal provided by an external reference, configured to control the stack 410) and as a negative input the output of a current regulating (GMI) amplifier 422. In this example, only a GMI amplifier loop is provided. However, the current sensing circuit 400 could similarly comprise a voltage regulating (GMV) amplifier loop. The chgr_cea_bat signal configures the charge error amplifier 420 for constant-current or constant-voltage regulation, depending upon the charging/discharge mode. The chgr_cea_bat signal may be based upon system voltage V_{sys}. By comparing the output of the system 100, the charge error amplifier 420 can output a maximum error signal to the transistor stack 410. The GMI amplifier 422 receives as a positive input a reference voltage V_{ref} (e.g., the A_{VDD} output of the power supply 125 shown in Figure 2) and as a negative input a feedback current signal I_{FB} from a drain of a current mirror transistor 430. The current mirror transistor 430 may form part of the current mirror 110 shown in Figures 1 and 2. A gate connection of the current mirror transistor 430 is coupled to the output of an amplifier 424.

The transistor stack 410 comprises two replicating transistors REP1, REP2. For the first replicating transistor REP1, a drain connection is coupled to the battery output voltage V_{bat} while a source connection is provided as an output. For the second replicating transistor REP2, a source connection is coupled to the system voltage V_{sys} while a drain connection is provided as an output.

The transistor stack 410 and the inputs to the amplifier 424/current mirror transistor 430 are selectively controlled via pairs of a switches. A first pair of switches S_{SPM} are closed when the system 100 is in the supplement mode. In the supplement mode, the source output of the first replicating transistor REP1 is provided to the source of the current mirror transistor 430 and to the positive input of the amplifier 424, and the system voltage V_{sys} is provided to the negative input of the amplifier 424 as chgr_imr_bat (a replicated control voltage of the transistor stack 410) . A second pair of switches S_{~SPM} are closed when the system 100 is not in the supplement mode. When not in the supplement mode, the drain output of the second replicating transistor REP2 is provided to the source of the current mirror transistor 430 and to the positive input of the amplifier 424, and the battery output voltage V_{bat} is provided to the negative input of the amplifier 424 as chgr_imr_bat.

In either case, at the drain connection of the current mirror transistor, a replicated current signal I_{REP} is output. A trim feedback value may be added to the replicated current signal I_{REP} via a varistor with variable resistance R_{FB}, the varistor being controlled by a trim controller 431.

The output of the current mirror transistor 430 (controlled as described above) is provided as a measured current signal I_{CHG}/I_{SPM} to a differential input circuit 440. The differential input circuit 440 comprises an operational amplifier 442, which outputs a positive signal V+ and a negative signal V- to the second multiplexer 130 / second ADC 132. The operational amplifier 442 may also be provided with a common mode input OCM. The common mode input may be the half the reference voltage provided by power supply converter 125a (e.g., A_{VDD}/2 as shown in Figure 2).

The differential input circuit 440 comprises a plurality of switchable input pathways, each set up across the operational amplifier 442 so as to provide a differential input. Each of the inputs corresponds to a charging/discharge mode of the system 100 and is selectable by groups of switches. The switches may be controllable by the AFE controller 150 or the charge controller 103, discussed above, for example.

A first group of switches S_{CHG}/S_{SPM} are closed when the system 100 is in the primary charging mode or the supplement mode. In this mode, the measured current signal I_{CHG}/I_{SPM} as measured via the current mirror is provided as a negative input to the operational amplifier 442, while a ground connection is provided as a positive input to the operational amplifier 442. These signals are each provided via one of a first pair of resistors R_{P1}. A first pair of differential input pathways, comprising a second pair of resistors Rₘ₁, are closed across both of the negative and positive input/output terminals of the operational amplifier 442. Together with the first pair of switches S_{SPM} and second pair of switches S_{~SPM}, this input can be used for either the primary charging mode of the supplement mode.

A second group of switches S_{DSG} are closed when the system 100 is in the discharge mode. In this mode, the battery output voltage V_{bat} (or measured battery output voltage V_{bat_sense}) is provided as a negative input to the operational amplifier 442, while the system voltage V_{sys} is provided as a positive input to the operational amplifier 442 (the battery output voltage V_{bat} and system voltage V_{sys} being taken across the charge control transistor 102 as shown in Figure 1). These signals are each provided via the drain-source resistance of one of a first pair of transistors R_{Ep2}. Gate connections of both of the transistors R_{Ep2} may share a common connection with the gate of the charge control transistor 102 (not shown in Figure 4). The charge control transistor 102 and the transistors R_{Ep2} may be the same type of transistor, so as to reduce gain and temperature drift. A second pair of differential input pathways, comprising a third pair of resistors Rₘ₂, are closed across both of the negative and positive input/output terminals of the operational amplifier 442.

A third group of switches S_{EXT} are closed when the system 100 utilises the external current sense resistor 210 for measuring the current. The battery voltage output V_{bat} is provided as a negative input to the operational amplifier 442, while the measured battery output voltage V_{bat_sense} is provided as a positive input to the operational amplifier 442 (the battery output voltage V_{bat} and measured battery voltage output V_{bat_sense} being taken across the external current sense resistor as shown in Figure 2). These signals are each provided via one of a fourth pair of resistors R_{P3}. A third pair of differential input pathways, comprising a fifth pair of resistors Rₘ₃, are closed across both of the negative and positive input/output terminals of the operational amplifier 442.

Each of the second pair of resistors Rₘ₁, the third pair of resistors Rₘ₂ and the fifth pair of resistors Rₘ₃ may be a varistor with variable resistance. The resistance of the varistors may be adjusted so as to match the resistance of the first pair of resistors Rₚ₁, first pair of transistors R_{Ep2} and fourth pair of resistors Rₚ₃, thereby reducing gain error of the operational amplifier 442.

By controlling the various switches discussed above, current can be sensed and provided to the ADC for further processing accordingly. Current can be measured in the primary charging mode when it is determined that an external power supply is connected and that a dropout condition has not occurred - switches S_{CHG}/S_{SPM} and switches S_{~SPM} will be closed. Current can be measured in the supplement mode when it is it is determined that an external power supply is connected and that a dropout condition has occurred - switches S_{CHG}/S_{SPM} and switches S_{SPM} will be closed. Current can be measured in the discharge mode when it is it is determined that an external power supply is not connected (or does not provide sufficient charging power) - switches S_{DSG} will be closed. Current can be measured when in any of the above modes but when using the external current sense resistor 210, rather than the charge control transistor 102 voltage drop of current mirror 110 - switches S_{EXT} will close. This external option (e.g., which of the charge conditions may use the external current sense resistor 210) may be defined in the OTP memory 170.

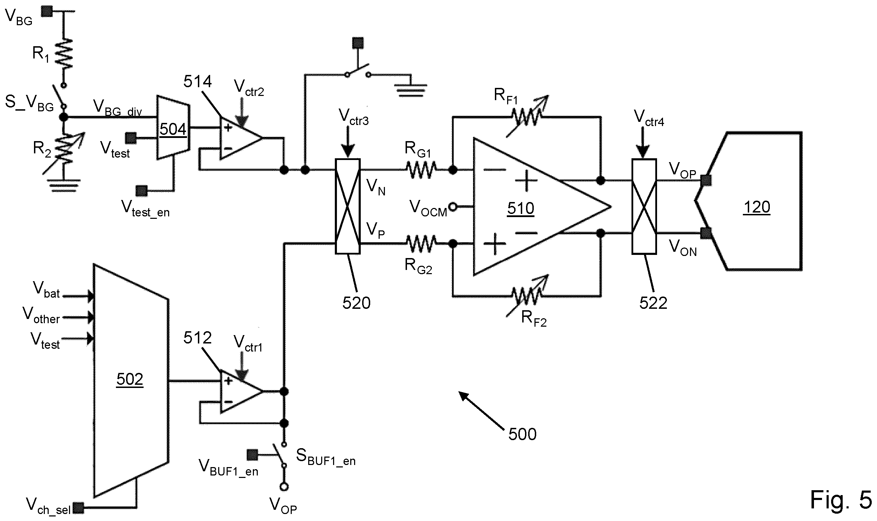

Figure 5 shows a schematic diagram of a voltage sensing circuit 500. The voltage sensing circuit 500 may be provided as part of the system 100 shown in Figures 1 and 2 for allowing the battery voltage to be measured using a differential input. The voltage sensing circuit 500 may be provided in addition to as or part of the first multiplexer 120, so as to provide voltage measurements to the first ADC 122.

A plurality of voltage signals are received at a first multiplexer 502, which may be the first multiplexer 120 of Figures 1 and 2. The received signals include the battery output voltage V_{bat} (and/or the measured battery output voltage V_{bat_sense}) and any other measured voltages Vₒₜₕₑᵣ, like those shown in Figure 2 (e.g., V_{T1}). A channel select signal V_{ch_sel} is provided to the first multiplexer 502 for selecting which of the received signals is output. The selected output signal is provided as the positive input to a second buffer amplifier 512. The second buffer amplifier 512 is selectively operable via a first control signal V_{ctr1}. The output of the second buffer amplifier 512 is looped as the negative input to the second buffer amplifier 512.

A reference voltage V_{BG} is also provided. The reference voltage V_{BG} is coupled in series with a resistor R1, a switch S_V_{BG} and a variable resistor R₂ to ground so as to produce a divided reference voltage V_{BG_div}. The battery output voltage V_{bat} and other measured voltages may similarly be passed through a resistor, switch, variable resistor arrangement (not shown) to produce a divided voltage. The divided reference voltage V_{BG_div} is provided as the positive input to a third buffer amplifier 514. The third buffer amplifier 514 is selectively operable via a first control signal Vctr2. The output of the third buffer amplifier 514 is looped as the negative input to the third buffer amplifier 514.

The outputs of the second buffer amplifier 512 and the third buffer amplifier 514 are provided as positive and negative inputs V_{P}, V_{N}, to the differential amplifier apparatus. The differential amplifier apparatus comprises a first crossed buffer 520 (selectively operable by a third control signal V_{ctr3}), a first buffer amplifier 510 (which may selectively be provided with a common mode input OCM), and a second crossed buffer 522 (selectively operable by a fourth control signal V_{ctr4}). Positive and negative inputs of the first buffer amplifier 510 each comprise one of a pair of resistors R_{G1}, R_{G2}. Differential pathways connect the negative input of the first buffer amplifier 510 to the positive output via a first variable resistor R_{F1}, and connect the positive input of the first buffer amplifier 510 to the negative output via a second variable resistor. The differential amplifier apparatus provides a positive output V_{OP} and a negative output V_{ON} to the first ADC 122.

The positive output V_{OP} is provided alongside the output of the second buffer amplifier 512, and may be selectively activated/deactivated via a first buffer enable switch S_{BUF1_en}, operated by a first buffer enable switch signal V_{BUF1_en}. The second and third buffer amplifiers may each be optionally provided with a test signal Vₜₑₛₜ, which may be used to test the operation of the voltage sensing circuit 500 and the wider system 100 prior to installation. The test signals Vₜₑₛₜ may be selected at the first and second multiplexers 502, 504 respectively via the channel select signal V_{ch_sel} and a test enable signal V_{test_en}.

When the battery output voltage V_{bat} channel is selected, all of the buffers in the voltage sensing circuit 500 may be operated so as to enable differential input control. By using the differential input and the reference signal V_{BG}, features of the battery output voltage V_{bat} may be zoomed in on (e.g., in a region of interest typical for the battery 200, such as 2.5 to 5 V). Alternatively, when other channels Vₒₜₕₑᵣ are selected and which may not benefit from differential input, only the second buffer amplifier 512 may be operated so as to only provide a single-ended input (e.g., V_{P} = V_{OP}).

From reading the present disclosure, other variations and modifications will be apparent to the skilled person. Such variations and modifications may involve equivalent and other features which are already known in the art of battery charging systems and methods, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A method of gauging a state of charge of a battery (200) in a chargeable device, the chargeable device comprising a battery charging circuit (101) comprising a charge control transistor (102), the charge control transistor being electrically coupled to the battery (200) and to a load of the chargeable device and selectively operable such that the battery charging circuit (101) can be selectively switched between a charging mode wherein an external power source is coupled to the battery charging circuit (101) for charging the battery, and a discharge mode wherein the battery (200) provides power to the load of the chargeable device, the method comprising:
measuring a current (I_{DSG}, I_{CHG}, I_{SPM}) at the charge control transistor (102);
measuring a voltage (V_{bat_sense}) of the battery (200);
providing the measured current (I_{DSG}, I_{CHG}, I_{SPM}) at the charge control transistor (102) and the voltage (V_{bat_sense}) of the battery (200) to a processor (300);
determining, using the processor (300), the state of charge of the battery (200).

2. The method of claim 1, wherein, when the battery charging circuit (1010) is in the discharge mode, measuring the current (I_{DSG}) at the charge control transistor (102) comprises:
measuring a voltage drop across a drain connection and a source connection of the charge control transistor (102); and
computing the current at the charge control transistor based on the measured voltage drop and an expected drain-source resistance (R_{DSon}) of the charge control transistor (102).

3. The method of claim 2, further comprising:
measuring a temperature (V_{T1}) of the charge control transistor (102) using a temperature sensor (140) located at or proximate to the charge control transistor (102); and
determining the expected drain-source resistance (Roson) based on the measured temperature (V_{T1}) of the charge control transistor (102).

4. The method of any preceding claim, wherein the battery charging circuit (101) further comprises a current mirror (110) electrically coupled to the charge control transistor (102), the current mirror (110) being configured to provide an output current (I_{CHG}, I_{SPM}) based on the current at the charge control transistor (102);
wherein measuring the current at the charge control transistor (102) comprises measuring the output current (I_{CHG}, I_{SPM}) of the current mirror (110).

5. The method of any preceding claim, wherein the charging mode of the battery charging circuit is either:
a primary charging mode (CHG), wherein a voltage (Vᵢₙ) and/or current provided by the external power source exceeds a respective voltage requirement (V_{sys}) and/or current requirement of the load, and the external power source provides charge to the battery (200); or
a supplement mode (SPM), wherein the voltage (Vᵢₙ) and/or current provided by the external power source is less than the respective voltage requirement (V_{sys}) and/or current requirement of the load, and battery (200) provides power to the load,
wherein the battery charging circuit (101) is configured to automatically switch between the primary charging mode (CHG) and the supplement mode (SPM) based upon measured voltages (Vᵢₙ, V_{sys}) and/or currents of the external power source and the load.

6. The method of any preceding claim, wherein the battery charging circuit (101) comprises a first analogue-to-digital converter, ADC (122), and a second ADC (132), wherein:
measuring the voltage of the battery (200) comprises receiving a raw battery voltage signal (V_{bat_sense}) at the first ADC (122), the first ADC (122) being configured to sample the raw battery voltage signal (V_{bat_sense}) and output discrete battery voltage data samples; and
measuring the current at the charge control transistor (102) comprises receiving a raw charge control transistor current signal (I_{CHG}, I_{DSG}, I_{SPM}) at the second ADC (132), the second ADC (132) being configured to sample the raw charge control transistor current signal (I_{CHG}, I_{DSG}, I_{SPM}) and output discrete charge control transistor current data samples,
wherein the first and second ADCs (122, 132) are configured to provide synchronised outputs such that each battery voltage data sample is associated with a charge control transistor current data sample.

7. The method of claim 6, wherein the battery charging circuit (101) further comprises a first multiplexer (120) provided at an input of the first ADC (122) and/or a second multiplexer (130) provided at an input of the second ADC (132), wherein the first multiplexer (120) and/or the second multiplexer (130) further receive signal data (Vₒₜₕₑᵣ) from one or more monitoring components of the battery charging circuit (101).

8. The method of claim 6 or claim 7, wherein each charge control transistor current data sample is appended with a mode identifier, the mode identifier indicating whether said charge control transistor current data sample was measured while the battering charging circuit (101) was in the charging mode (CHG/SPM) or the discharge mode (DSG).

9. The method of any preceding claim, wherein the battery charging circuit (101) further comprises a buffer memory (160), wherein providing the measured current (I_{CHG}, I_{DSG}, I_{SPM}) at the charge control transistor (102) and the measured voltage (V_{bat_sense}) of the battery (200) to the processor (300) comprises:
storing a plurality of charge control transistor current measurements and a plurality of battery voltage measurements in the buffer memory (160); and
passing the plurality of charge control transistor current measurements and plurality of battery voltage measurements from the buffer memory (160) to the processor (300).

10. The method of any of claims 6 to 9, wherein a sample rate of the first ADC (122) and a sample rate of the second ADC (132) is varied based on whether the battery charging circuit (101) is in the charging mode (CHG/SPM) or the discharge mode (DSG); and/or
the method of claim 9, wherein a frequency at which measurements are passed from the buffer memory (160) to the processor (300) is varied based on whether the battery charging circuit (101) is in the charging mode (CHG/SPM) or the discharge mode (DSG).

11. The method of any preceding claim, wherein determining the state of charge of the battery (200) comprises using an IR corrected voltage correlation model.

12. The method of any preceding claim, wherein measuring the voltage (V_{bat}) of the battery (200) comprises taking a differential measurement of the voltage (V_{bat}) of the battery (200), the differential measure comprising applying a reference offset voltage (V_{BG}) to the measured voltage (V_{bat}).

13. A system (100) for gauging a state of charge of a battery (200) in a chargeable device, the system (100) comprising:
a battery charging circuit (101) comprising:
a charge control transistor (102), the charge control transistor (102) being electrically coupled to the battery (200) and to a load of the chargeable device and selectively operable such that the battery charging circuit (101) can be selectively switched between a charging mode wherein an external power source is coupled to the battery charging circuit (101) for charging the battery, and a discharge mode wherein the battery (200) provides power to the load of the chargeable device;
a current measuring pathway configured to measure a current (I_{CHG}, I_{DSG}, I_{SPM}) at the charge control transistor (102);
a voltage measuring pathway configured to measure a voltage (V_{bat_sense}) of the battery (200);
a first analogue-to-digital converter, ADC (122), coupled to the voltage measuring pathway, the first ADC (122) being configured to receive a raw battery voltage signal (V_{bat_sense}) and output discrete battery voltage data samples; and
a second ADC (132) coupled to the current measuring pathway, the second ADC (132) being configured to receive a raw charge control transistor current signal (I_{CHG}, I_{DSG}, I_{SPM}) and output discrete charge control transistor current data samples, wherein the first ADC (122) and the second ADC (132) are configured to provide synchronised outputs; and
a processor (300), the processor (300) being coupled to the first and second ADCs (122, 132) and being configured to determine a state of charge of the battery (200) based upon the measured current (I_{CHG}, I_{DSG}, I_{SPM}) at the charge control transistor (102) and the measured voltage (V_{bat_sense}) of the battery (200).

14. The system (100) of claim 13, wherein the battery charging circuit (101) further comprises a buffer memory (160) configured to:
receive the outputs of the first ADC (122) and the second ADC (132);
store a plurality of charge control transistor current measurements and a plurality of battery voltage measurements; and
pass the plurality of charge control transistor current measurements and plurality of battery voltage measurements from the buffer memory (160) to the processor (300).

15. The system (100) of claim 13 or 14, wherein the chargeable device is a wearable device and/or wherein the battery (200) has a maximum storage capacity of less than 500 mAh.
